(19) Europäisches Patentamt
European Patent Office
Office européen des brevets

(11) **EP 3 389 256 B1**

(12) **EUROPEAN PATENT SPECIFICATION**

(45) Date of publication and mention
of the grant of the patent:
**12.04.2023 Bulletin 2023/15**

(21) Application number: **16882888.7**

(22) Date of filing: **06.01.2016**

(51) International Patent Classification (IPC):
*H04N 5/369* ^(2011.01)   *H04N 13/271* ^(2018.01)
*H04N 5/232* ^(2006.01)   *H01L 27/14* ^(2006.01)

(52) Cooperative Patent Classification (CPC):
**H04N 13/271; H04N 25/704;** H01L 27/14;
H04N 23/672

(86) International application number:
**PCT/CN2016/070275**

(87) International publication number:
**WO 2017/117743 (13.07.2017 Gazette 2017/28)**

(54) **METHOD AND DEVICE FOR PROCESSING IMAGE**

VERFAHREN UND VORRICHTUNG ZUR VERARBEITUNG VON BILDERN

PROCÉDÉ ET DISPOSITIF DE TRAITEMENT D'IMAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**17.10.2018 Bulletin 2018/42**

(73) Proprietor: **Huawei Technologies Co., Ltd.
Longgang District
Shenzhen, Guangdong 518129 (CN)**

(72) Inventor: **WAN, Wah Tung Jimmy
Shenzhen
Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
**CN-A- 103 108 193      CN-A- 103 852 954
CN-A- 103 852 967      CN-A- 104 052 919
JP-A- 2015 228 466     US-A1- 2015 043 826
US-A1- 2015 248 744    US-A1- 2015 319 420
US-A1- 2015 350 529    US-A1- 2017 267 178**

**Description**

**TECHNICAL FIELD**

Embodiments of the present invention relate to the field of image processing technologies, and more specifically, to an image processing method and device.

**BACKGROUND**

A depth map reflects depth information of an image. The depth information indicates a distance between an object in the image and a camera. A pixel of the depth map may be used to reflect information about a distance between a corresponding area and the camera.

In the prior art, a manner of obtaining a depth map is quite complex. A common manner of obtaining a depth map is to take multiple photographs by using different positions as focus. For example, a depth map may be obtained by using a dual camera. Specifically, a dual camera is a camera with two independent image sensors. One photograph is taken by using each image sensor. Focus of one photograph is on a distant view, and focus of the other photograph is on a nearby view. The depth map may be generated according to the two photographs. However, a dual camera has quite high costs. For another example, alternatively, a depth map may be obtained by taking multiple photographs with different focus by using a common camera. However, in this manner, photographs with different focus are taken at different times. Therefore, this manner is not quite suitable for photographing a moving object. Another manner of obtaining a depth map is a system solution based on time of flight. In the solution, an independent light-emitting unit is required. The light-emitting unit is configured to illuminate an object that needs to be photographed. Another independent sensor photographs light and calculates a time required by the light to reach the target object. According to a transmission time of the light, a distance to the target object can be calculated, and the depth map can be generated.

In the foregoing solutions, a manner of obtaining a depth map is complex, or a device for obtaining a depth map has high costs.

US 2017/267178 A1 discloses an image capture device that is mounted in a vehicle. The image capture device includes: an image capture unit; and a setting unit that sets an image capture condition for each region of the image capture unit each having a plurality of pixels, or for each pixel, based upon at least one of a state exterior to the vehicle and a state of the vehicle.

US 2015/043826 A1 discloses an image processing apparatus, including: an image processor configured to process an image of a first frame based on depth information of the first frame and depth information of a second frame before the first frame, the depth information indicating a position of an object in an image in a depth direction.

US 2015/319420 A1 discloses an image sensor that may include phase detection pixels that receive and convert incident light into pixel signals. Processing circuitry may use pixel signals from the phase detection pixels to determine an amount by which image sensor optics should be adjusted during automatic focusing operations. Phase detection pixels may include photodiodes with asymmetric angular responses. For example, the center of a photodiode in a phase detection pixel may be offset from the optical center of the microlens that covers that photodiode. A group of two, three, four, or more than four phase detection pixels may be clustered together and covered by a single microlens. Groups of these clusters may be arranged consecutively in a line. Phase data may be gathered using all of the phase detection pixels in the array, and image processing circuitry may determine which phase data to use after the data has been gathered.

US 2015/248744 A1 discloses an image processing device, an image processing method, and an information processing device, in which a high-resolution viewpoint image and a disparity map can be obtained with a simple configuration. A resolution conversion unit converts a resolution of a viewpoint image imaged at a central viewpoint at first resolution to a resolution of a viewpoint image imaged at a peripheral viewpoint at second resolution which is lower than the first resolution, and generates the viewpoint image at the central viewpoint and the viewpoint image at the peripheral viewpoint both having a same resolution. A correlation value calculation unit generates a disparity map based on a correlation value between the viewpoint image at the central viewpoint and the viewpoint image at the peripheral viewpoint both having the same resolution. The present technology is applicable to an information processing device.

**SUMMARY**

Embodiments of the present invention provide an image processing method as defined in claim 1 and an image processing device as defined in claim 7, so as to provide a simple manner of obtaining a depth map. Further advantageous implementation of the image processing method and the image processing device are defined in the dependent claims.

## BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts falling into the scope of the appended claims.

FIG. 1 is a schematic diagram of an input image;
FIG. 2 is a schematic flowchart of an image processing method according to an embodiment of the present invention;
FIG. 3 is a schematic diagram of dividing the input image into four area windows in a first direction;
FIG. 4 is a schematic diagram of dividing the input image into six area windows in both a first direction and a second direction;
FIG. 5 is a schematic diagram of determining a depth map according to a phase difference;
FIG. 6 is a structural block diagram of an image processing device according to an embodiment of the present invention; and
FIG. 7 is a structural block diagram of a device according to an embodiment of the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention as defined by the appended claims.

A digital camera obtains an image by using an image sensor instead of a conventional film. Photosensitive elements are evenly distributed in the image sensor, and are configured to convert an optical image into an electrical signal to finally generate an image. Phase focusing is a method for focusing by using a special photosensitive element in an image sensor.

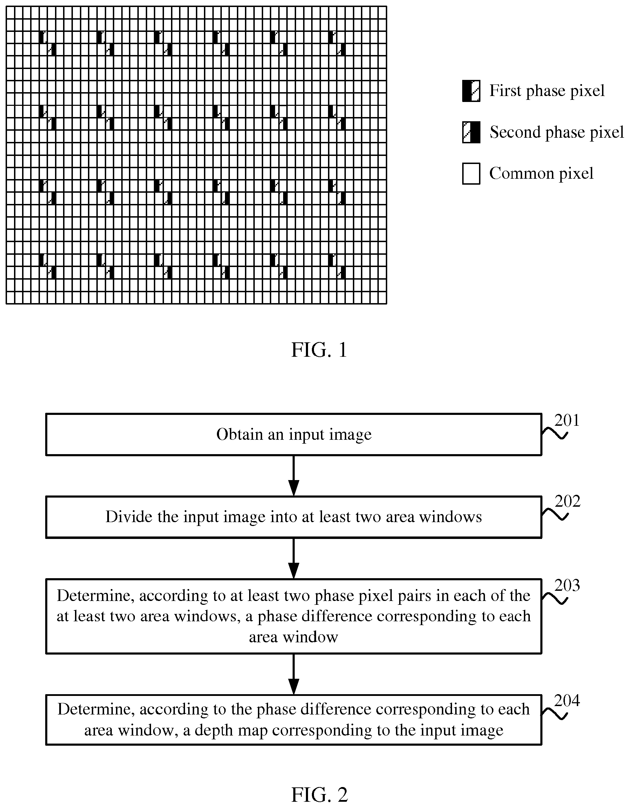

FIG. 1 is a schematic diagram of an image sensor that can implement phase focusing. Multiple photosensitive elements are evenly distributed in the image sensor shown in FIG. 1. There is a type of special photosensitive element in the photosensitive elements. This type of special photosensitive element is a common photosensitive element that is half blocked. Phase focusing is implemented by calculating a phase difference by using a signal that is obtained by this type of special photosensitive element.

The foregoing signal is obtained by multiple photosensitive elements. Each photosensitive element obtains only a sample (sample) in the signal. For ease of description, in the following content, a sample obtained by a special photosensitive element used for phase focusing is referred to as a phase pixel (phase pixel), a sample obtained by a common photosensitive element is referred to as a common pixel, and an image sensor that can obtain a phase pixel to implement phase focusing is referred to as an image sensor with a phase pixel.

More specifically, a phase pixel is further classified into a first phase pixel and a second phase pixel. The first phase pixel is obtained by a photosensitive element that is blocked on the left side. The second phase pixel is obtained by a photosensitive element that is blocked on the right side. An input image in the present invention is an original signal obtained by an image sensor with a phase pixel, rather than a photograph obtained by performing a series of subsequent processing. One photosensitive element in the image sensor with a phase pixel corresponds to one pixel in the input image. Pixels in the input image are a phase pixel and a common pixel. Therefore, FIG. 1 may also be considered as a schematic diagram of the input image.

It can be learnt from FIG. 1 that the input image includes multiple common pixels and multiple phase pixel pairs. Each phase pixel in the multiple phase pixel pairs includes a first phase pixel and a second phase pixel. The first phase pixel and the second phase pixel in each phase pixel pair in the input image shown in FIG. 1 are located in adjacent pixel rows, and the second phase pixel is located in a column that is adjacent to and on the right of a column in which the first phase pixel is located. Certainly, phase pixel pair arrangement shown in FIG. 1 is merely one embodiment. There may also be another phase pixel pair arrangement manner. This is not limited in the present invention. However, a shorter distance between two phase pixels that constitute one phase pixel pair indicates higher precision of phase difference calculation.

FIG. 2 is a schematic flowchart of an image processing method according to an embodiment of the present invention.

201: Obtain an input image.

202: Divide the input image into at least two area windows, where each of the at least two area windows includes at least two adjacent phase pixel pairs of the multiple phase pixel pairs.

203: Determine, according to the at least two phase pixel pairs in each of the at least two area windows, a phase difference (English: Phase Difference, PD for short) corresponding to each area window.

204: Determine, according to the phase difference corresponding to each area window, a depth map corresponding to the input image.

According to the method shown in FIG. 2, the input image is obtained by using an image sensor that can obtain a phase pixel. A phase difference of each area window can be determined according to phase pixels in the area window. In this way, the depth map can be determined. In the foregoing technical solution, the depth map is obtained without photographing multiple input images or using any other auxiliary device.

Dividing the input image into at least two area windows includes: dividing, by using a first length as a step, at least one part of the input image in a first direction into at least two area windows whose sizes are the same, where the first direction is a horizontal direction of the input image or a vertical direction of the input image.

A specific value of the first length is determined according to a required resolution in the first direction. A lower resolution indicates a larger value of the first length. A higher resolution indicates a smaller value of the first length. However, the first length is greater than or equal to a distance between two adjacent phase pixels in the first direction. This can ensure that there are different phase pixel pairs in any two adjacent area windows in the first direction.

Optionally, in an embodiment, the first length may also be less than a length of each area window in the first direction. In another embodiment, the first length may be equal to a length of each area window in the first direction. If the first length is greater than or equal to the distance between two adjacent phase pixels in the first direction and the first length is less than the distance of each area window in the first direction, there is a common phase pixel pair in any two adjacent area windows in the first direction, that is, area windows obtained in the first direction overlap. If the first length is equal to the distance of each area window in the first direction, at least one part of the input image in the first direction is equally divided into at least two area windows that have no common phase pixel pair, that is, obtained area windows do not overlap. It can be easily understood that, compared with a case in which area windows do not overlap, more area windows can be obtained by means of division when area windows overlap.

Specifically, the first length may be determined by using the following formula:

$$s = (W - ROI_W)/(r_h - 1) \quad \text{(Formula 1.1)},$$

where s represents a first length, W represents a length of an input image in a first direction, ROIw represents a length of an area window in the first direction, and $r_h$ represents a resolution that is expected to be obtained in the first direction.

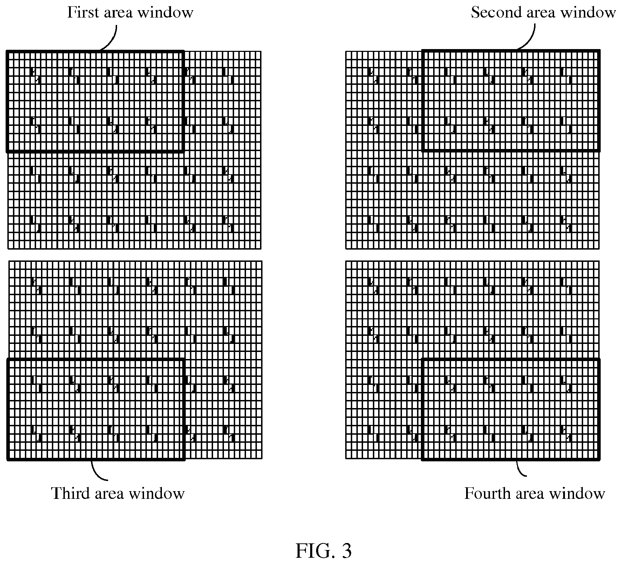

FIG. 3 is a schematic diagram of dividing the input image into four area windows in a first direction. As shown in FIG. 3, an upper half part of the input image is first divided into a first area window and a second area window in a horizontal direction by using a first length as a step. Then, a lower half part of the input image is divided into a third area window and a fourth area window in the horizontal direction by using the first length as the step. It can be learnt that the first length is greater than a distance between two adjacent phase pixel pairs in the horizontal direction, and the first length is less than a length of the area window in the horizontal direction.

It can be understood that the schematic diagram shown in FIG. 3 shows the four different area windows by using four images. However, the four images shown in FIG. 3 are the same input image. A purpose of showing the four different area windows by using the four images is merely to indicate locations of the different area windows more clearly.

It can be learnt that there are common phase pixel pairs in the first area window and the second area window (that is, the third phase pixel pairs and the fourth phase pixel pairs in the first and the second rows of phase pixel pairs), and there are also common phase pixel pairs in the third area window and the fourth area window (that is, the third phase pixel pairs and the fourth phase pixel pairs in the third and the fourth rows of phase pixel pairs).

Certainly, the input image may alternatively be divided into at least two area windows in a vertical direction. A specific process is similar to the process, shown in FIG. 3, of dividing the input image in the horizontal direction. Details are not described herein again.

Further, the dividing the input image into at least two area windows further includes: dividing, by using a second length as a step, at least one part of the input image in a second direction into at least two area windows whose sizes are the same, where the second direction is perpendicular to the first direction. The second length is greater than or equal to a distance between two adjacent phase pixels in the second direction. The second length is less than a distance of each area window in the second direction. Only in this way, it can be ensured that there are different phase pixel pairs in any two adjacent area windows in the second direction and that there is a common phase pixel pair in any two adjacent area windows in the second direction. That is, any two adjacent area windows in the second direction overlap. A specific manner of determining the second length is the same as that of determining the first length, and details are not described herein again.

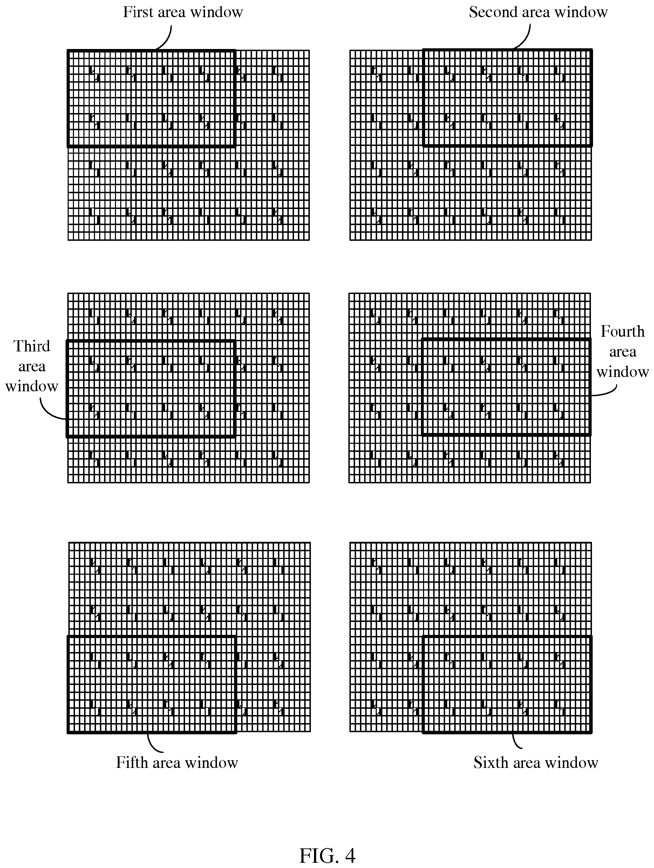

FIG. 4 is a schematic diagram of dividing the input image into six area windows in both a first direction and a second direction.

As shown in FIG. 4, the input image is divided into the six area windows by using a first length as a step and by using a second length as a step. It can be learnt that the first length is greater than a distance between two adjacent phase pixel pairs in a horizontal direction, and the first length is less than a length of the area window in the horizontal direction. The first length is greater than a distance between two adjacent phase pixel pairs in a vertical direction, and the first length is less than a length of the area window in the vertical direction.

Similar to FIG. 3, the schematic diagram shown in FIG. 4 shows the six different area windows by using six images. However, the six images shown in FIG. 4 are the same input image. A purpose of showing the six different area windows by using the six images is merely to indicate locations of the different area windows more clearly.

It can be learnt that, for a same input image, a quantity of area windows obtained by performing area window division in one direction is less than a quantity of area windows obtained by performing area window division in two directions.

Optionally, in another embodiment, the dividing the input image into at least two area windows includes: equally dividing the input image into at least two area windows whose sizes are the same, where there is no same phase pixel pair in two adjacent area windows.

After the area windows are determined, the phase difference corresponding to each area window can be determined. Apparently, a larger quantity of area windows leads to more phase differences of the input image and a higher resolution of the depth map of the input image.

If area windows that do not overlap are used, an obtained resolution of the depth map is:

$$\begin{cases} r_h = W \; / \; ROI_W \\ r_v = H \; / \; ROI_H \end{cases} \quad \text{(Formula 1.2)},$$

where W represents a length of an input image in a first direction, $ROI_W$ represents a length of an area window in the first direction, $r_h$ represents a first-direction resolution, H represents a length of the input image in a second direction, $ROI_h$ represents a length of the area window in the second direction, and $r_v$ represents a second-direction resolution.

If the area windows overlap only in the first direction, because the first length is less than the length of the area window in the first direction, a first-direction resolution of the depth map of the first image is higher than a resolution that is obtained when overlapped area windows are not used. Similarly, if the area windows overlap only in the second direction, because the second length is less than the length of the area window in the second direction, a second-direction resolution of the depth map of the first image is higher than a resolution that is obtained when overlapped area windows are not used. It can be understood that, if the area windows overlap in both the first direction and the second direction, both a first-direction resolution and a second-direction resolution of the depth map of the first image are higher than a resolution that is obtained when overlapped area windows are not used.

Specifically, if the area windows overlap in both the first direction and the second direction, an obtained resolution of the depth map is:

$$\begin{cases} r_h = W \; / \; s_w \\ r_v = H \; / \; s_h \end{cases} \quad \text{(Formula 1.3)},$$

where W represents a length of an input image in a first direction, $s_w$ represents a first length of an area window, $r_h$ represents a first-direction resolution, H represents a length of the input image in a second direction, $s_h$ represents a second length, and $r_v$ represents a second-direction resolution.

The phase difference corresponding to each area window can be obtained according to a cross correlation in the area window. Specifically, a cross correlation of each phase pixel pair in the first direction in each area window may be determined by using the following formula:

$$f(x) * k(x) = \sum_{i=-T+1}^{T-1} f(x) k(x+i) \quad \text{(Formula 1.4)},$$

where $f(x) * k(x)$ represents a cross correlation of a phase pixel pair in a first direction, $f(x)$ represents a second phase pixel signal in the phase pixel pair in the first direction, $k(x)$ represents a first phase pixel signal in the phase pixel pair in the first direction, and T represents a signal width.

After the cross correlation is determined, each phase difference in the first direction may be determined. A person skilled in the art knows a specific process of determining a phase difference according to a cross correlation, and details are not described herein. Similarly, each phase difference in the first direction in each area window may be determined. After each phase difference in the first direction is determined, the phase difference corresponding to each area window may be determined by using the following formula:

$$PD(ROI) = \frac{1}{n}\sum_{n=1}^{n} PD(n)$$

,

where PD(ROI) represents a phase difference corresponding to an area window, n represents a quantity of phase pixel pairs in a first direction in the area window, and PD(n) represents a phase difference of the $n^{th}$ phase pixel pair in the first direction. After the phase difference corresponding to each area window is determined, the depth map corresponding to the input image may be determined according to the phase difference corresponding to each area window.

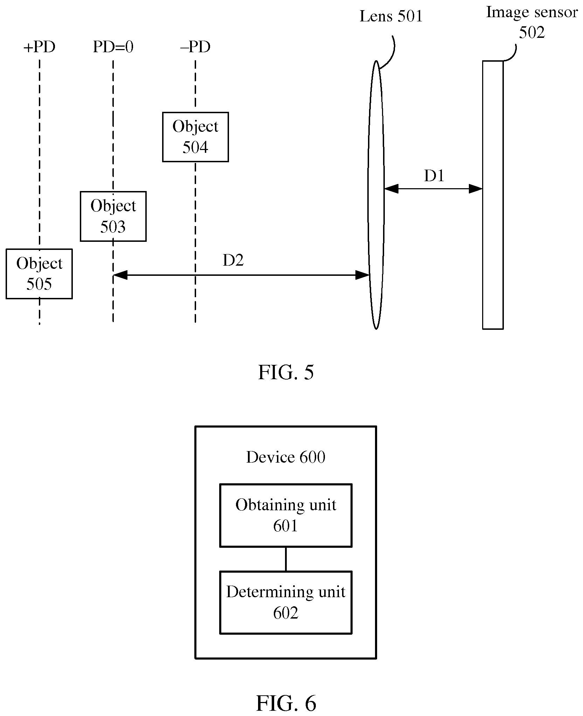

FIG. 5 is a schematic diagram of determining a depth map according to a phase difference. In the schematic diagram shown in FIG. 5, there are a lens 501 and an image sensor 502 of a camera. A distance between the lens 501 and the image sensor 502 is D1. In the schematic diagram shown in FIG. 5, there are also photographed objects, including an object 503, an object 504, and an object 505.

As shown in FIG. 5, it is assumed that a distance between focus and the lens 501 is D2. In this case, a phase difference of the object 503 on the focus is 0. A distance between the object 504 and the lens 501 is less than D2. Therefore, a phase difference of the object 504 is negative. A distance between the object 505 and the lens 501 is greater than D2. Therefore, a phase difference of the object 505 is positive. Because phase differences of objects at different distances to a lens are different, information about a distance between an object and the lens may be reflected by using a phase difference. That is, phase differences can reflect depth information of different objects. A phase difference of an object on focus is 0. An object closer to the lens 501 has a smaller phase difference. An object farther from the lens 501 has a larger phase difference.

Therefore, after a phase difference corresponding to each area window is determined, a depth map corresponding to an input image may be determined according to the phase difference corresponding to each area window. The depth map may be a greyscale image. In this case, different phase differences may correspond to different grayscale values. Because a phase difference obtained according to the method shown in FIG. 2 is a phase difference corresponding to one area window, one area window corresponds to one grayscale value. If phase differences corresponding to two area windows are different, grayscale values of the two area windows are also different. For example, a larger phase difference indicates a larger grayscale value, and a smaller phase difference indicates a smaller grayscale value. Alternatively, the depth map may be a color image. In this case, different phase differences may correspond to different colors. Because a phase difference obtained according to the method shown in FIG. 2 is a phase difference corresponding to one area window, one area window corresponds to one color. If phase differences of two area windows are different, colors of the two area windows are also different. Therefore, a larger quantity of area windows leads to more phase differences of the input image and a higher resolution of the depth map of the input image.

The first area window in FIG. 3 is used as an example. A first cross correlation may be determined according to a signal of a second phase pixel in a phase pixel pair of the first row in the first area window and a signal of a first phase pixel in the phase pixel pair of the first row in the first area window. A second cross correlation may be determined according to a signal of a second phase pixel in a phase pixel pair of the second row in the first area window and a signal of a first phase pixel in the phase pixel pair of the second row in the first area window. A first phase difference PDi is determined according to the first cross correlation. A second phase difference $PD_2$ is determined according to the second cross correlation. Then, it can be determined that a phase difference corresponding to the first area window is $(PD_1+PD_2)/2$. Phase differences corresponding to all area windows in the input image can be determined in a similar manner. Then, a depth map of the input image can be determined according to the phase differences corresponding to all the area windows.

It can be understood by a person skilled in the art that the input image shown in FIG. 1, FIG. 3, and FIG. 4 is merely a schematic diagram. The area window size, the first length, and the second length shown in the figures are also merely examples. For example, in actual application, a minimum length of an area window may be $20 \times p_s$, where $p_s$ is a distance between two adjacent phase pixels. A width of an area window may be a sum of lengths of phase pixel pairs of at least two columns. If a length of an area window is excessively small, precision of a calculated phase difference is reduced.

In addition, a person skilled in the art can understand that the length, distance, and resolution in this embodiment of the present invention are all in units of pixels.

FIG. 6 is a structural block diagram of an image processing device according to an embodiment of the present invention. The device 600 shown in FIG. 6 can execute each step of the method shown in FIG. 2. The device 600 shown in FIG. 6 includes an obtaining unit 601 and a determining unit 602.

The obtaining unit 601 is configured to obtain an input image. The input image includes multiple common pixels and multiple phase pixel pairs. Each of the multiple phase pixel pairs includes a first phase pixel and a second phase pixel. The first phase pixel is a phase pixel that is blocked on the left side, and the second phase pixel is a phase pixel that is blocked on the right side.

The determining unit 602 is configured to divide the input image into at least two area windows, where each of the at least two area windows includes at least two adjacent phase pixel pairs of the multiple phase pixel pairs.

The determining unit 602 is further configured to determine, according to the at least two phase pixel pairs in each of the at least two area windows, a phase difference corresponding to each area window.

The determining unit 602 is further configured to determine, according to the phase difference corresponding to each area window, a depth map corresponding to the input image.

The device shown in FIG. 6 can determine the depth map according to phase pixels. The device does not need multiple input images or any other auxiliary device to obtain the depth map.

The determining unit 602 is specifically configured to divide, by using a first length as a step, at least one part of the input image in a first direction into at least two area windows whose sizes are the same. The first direction is a horizontal direction of the input image or a vertical direction of the input image.

Further, the first length is greater than or equal to a distance between two adjacent phase pixels in the first direction. This can ensure that there are different phase pixel pairs in any two adjacent area windows in the first direction. Further, the first length may also be less than a length of each area window in the first direction. This can ensure that there is a same phase pixel pair in any two adjacent area windows in the first direction.

Further, the determining unit 602 is further configured to divide, by using a second length as a step, at least one part of the input image in a second direction into at least two area windows whose sizes are the same. The second direction is perpendicular to the first direction.

Further, the second length is greater than or equal to a distance between two adjacent phase pixels in the second direction. This can ensure that there are different phase pixel pairs in any two adjacent area windows in the second direction. Further, the second length may also be less than a length of each area window in the second direction. This can ensure that there is a same phase pixel pair in any two adjacent area windows in the second direction.

The determining unit 602 is specifically configured to: determine, according to the at least two phase pixel pairs in each of the at least two area windows, a cross correlation between a first phase pixel and a second phase pixel in each area window; and determine, according to the cross correlation between a first phase pixel and a second phase pixel in each area window, the phase difference corresponding to each area window.

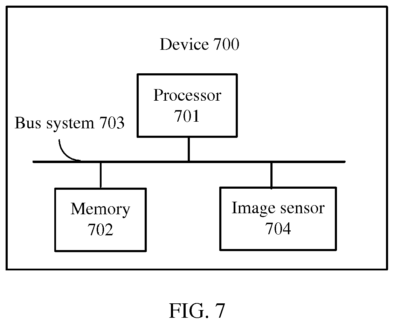

FIG. 7 is a structural block diagram of an image processing device according to an embodiment of the present invention. The device 700 shown in FIG. 7 includes a processor 701 and a memory 702.

All components of the device 700 are coupled to each other by using a bus system 703. The bus system 703 not only includes a data bus but also includes a power bus, a control bus, and a status signal bus. However, for clear description, various buses in FIG. 7 are all marked as the bus system 703.

The methods disclosed in the foregoing embodiments of the present invention may be applied to the processor 701 or implemented by the processor 701. The processor 701 may be an integrated circuit chip and has a signal processing capability. In an implementation process, the steps of the foregoing methods may be completed by using an integrated logic circuit of hardware in the processor 701 or by using an instruction in a form of software. The foregoing processor 701 may be a general purpose processor, a digital signal processor (Digital Signal Processor, DSP), an application-specific integrated circuit (Application Specific Integrated Circuit, ASIC), a field programmable gate array (Field Programmable Gate Array, FPGA) or another programmable logic device, a discrete gate or a transistor logic device, or a discrete hardware component, and can implement or execute the methods, steps, and logical block diagrams disclosed in the embodiments of the present invention. The general purpose processor may be a microprocessor, or the processor may be any conventional processor or the like. The steps of the methods disclosed with reference to the embodiments of the present invention may be directly executed by a hardware decoding processor, or may be executed by using a combination of hardware in a decoding processor and a software module. The software module may be located in a storage medium that is mature in the art, such as a random access memory (Random Access Memory, RAM), a flash memory, a read-only memory (Read-Only Memory, ROM), a programmable ROM or an electrically erasable programmable memory, or a register. The storage medium is located in the memory 702. The processor 701 reads an instruction in the memory 702, and completes the steps of the foregoing methods in combination with hardware of the processor 701.

The processor 701 is configured to obtain an input image. The input image includes multiple common pixels and multiple phase pixel pairs. Each of the multiple phase pixel pairs includes a first phase pixel and a second phase pixel. The first phase pixel is a phase pixel that is blocked on the left side, and the second phase pixel is a phase pixel that is blocked on the right side.

Optionally, in an embodiment, the device 700 may further include an image sensor 704, configured to photograph the input image. The image sensor 704 includes a sensing element configured to obtain the common pixel, the first phase pixel, and the second phase pixel. In this case, the processor 701 is specifically configured to obtain the input image from the image sensor 704.

The processor 701 is further configured to divide the input image into at least two area windows, where each of the at least two area windows includes at least two adjacent phase pixel pairs of the multiple phase pixel pairs.

The processor 701 is further configured to determine, according to the at least two phase pixel pairs in each of the at least two area windows, a phase difference corresponding to each area window.

The processor 701 is further configured to determine, according to the phase difference corresponding to each area window, a depth map corresponding to the input image.

The device shown in FIG. 7 can determine the depth map according to phase pixels. The device does not need multiple input images or any other auxiliary device to obtain the depth map.

Optionally, in an embodiment, the processor 701 is specifically configured to divide, by using a first length as a step, at least one part of the input image in a first direction into at least two area windows whose sizes are the same. The first direction is a horizontal direction of the input image or a vertical direction of the input image.

Further, the first length is greater than or equal to a distance between two adjacent phase pixels in the first direction. This can ensure that there are different phase pixel pairs in any two adjacent area windows in the first direction. Further, the first length may also be less than a length of each area window in the first direction. This can ensure that there is a same phase pixel pair in any two adjacent area windows in the first direction.

Further, the processor 701 is further configured to divide, by using a second length as a step, at least one part of the input image in a second direction into at least two area windows whose sizes are the same. The second direction is perpendicular to the first direction.

Further, the second length is greater than or equal to a distance between two adjacent phase pixels in the second direction. This can ensure that there are different phase pixel pairs in any two adjacent area windows in the second direction. Further, the second length may also be less than a length of each area window in the second direction. This can ensure that there is a same phase pixel pair in any two adjacent area windows in the second direction.

The processor 701 is specifically configured to: determine, according to the at least two phase pixel pairs in each of the at least two area windows, a cross correlation between a first phase pixel and a second phase pixel in each area window; and determine, according to the cross correlation between a first phase pixel and a second phase pixel in each area window, the phase difference corresponding to each area window.

A person of ordinary skill in the art may be aware that units and algorithm steps in examples described with reference to the embodiments disclosed in this specification may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that such an implementation goes beyond the scope of the present invention as defined in the appended claims.

It can be clearly understood by a person skilled in the art that, for the purpose of convenient and brief description, for detailed working processes of the foregoing systems, apparatuses, and units, reference may be made to corresponding processes in the foregoing method embodiments, and details are not described herein again.

In the several embodiments provided in this application, it should be understood that the disclosed systems, apparatuses, and methods may be implemented in other manners. For example, the described apparatus embodiment is merely an example. For example, the unit division is merely logical function division and may be other division in actual implementation. For example, multiple units or components may be combined or may be integrated into another system, or some features may be ignored or not performed. In addition, the displayed or discussed mutual couplings, direct couplings, or communication connections may be implemented by using some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on multiple network units. Some or all of the units may be selected according to actual needs, to achieve the objectives of the solutions in the embodiments.

In addition, functional units in the embodiments of the present invention may be integrated into one processing unit, or each of the units may exist alone physically, or two or more units may be integrated into one unit.

When the functions are implemented in a form of a software functional unit, and are sold or used as an independent product, the functions may be stored in a computer readable storage medium. Based on such an understanding, the technical solutions of the present invention essentially, or the part contributing to the prior art, or some of the technical solutions may be implemented in a form of a software product. The computer software product is stored in a storage medium, and includes several instructions for instructing a computer device (which may be a personal computer, a server, a network device, or the like) or a processor (processor) to perform all or some of the steps of the methods described in the embodiments of the present invention. The foregoing storage medium includes any medium that can store program code, such as a USB flash drive, a removable hard disk, a read-only memory (ROM, Read-Only Memory), a random access memory (RAM, Random Access Memory), a magnetic disk, or an optical disc.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. An image processing method, wherein the method comprises:

   obtaining (201) an input image, wherein the input image comprises multiple common pixels and multiple phase pixel pairs, each of the multiple phase pixel pairs comprises a first phase pixel and a second phase pixel, the first phase pixel is obtained by a photosensitive element that is blocked on the left side, and the second phase pixel is obtained by a photosensitive element that is blocked on the right side;
   dividing (202) the input image into at least two area windows, wherein each of the at least two area windows comprises at least two adjacent phase pixel pairs of the multiple phase pixel pairs;
   determining (203), according to the at least two phase pixel pairs in each of the at least two area windows, a phase difference corresponding to each area window; and
   determining (204), according to the phase difference corresponding to each area window, a depth map corresponding to the input image,
   **characterized in that** the method further comprises determining a first length according to a required resolution of the depth map in a first direction, wherein the first length is greater than or equal to a distance between two adjacent phase pixel pairs in the first direction, and
   that the dividing the input image into at least two area windows comprises:
   dividing, by using the first length as a step, at least one part of the input image in a first direction into at least two area windows whose sizes are the same, wherein the first direction is a horizontal direction of the input image or a vertical direction of the input image.

2. The method according to claim 1, wherein the first length is less than a length of each area window in the first direction.

3. The method according to claim 1 or 2, wherein the dividing (202) the input image into at least two area windows further comprises:
   dividing, by using a second length as a step, at least one part of the input image in a second direction into at least two area windows whose sizes are the same, wherein the second direction is perpendicular to the first direction.

4. The method according to claim 3, wherein the second length is greater than or equal to a distance between two adjacent phase pixel pairs in the second direction.

5. The method according to claim 3 or 4, wherein the second length is less than a length of each area window in the second direction.

6. The method according to any one of claims 1 to 5, wherein the determining, according to the at least two phase pixel pairs in each of the at least two area windows, a phase difference corresponding to each area window comprises:

   determining, according to the at least two phase pixel pairs in each of the at least two area windows, a cross correlation between a first phase pixel and a second phase pixel in each area window; and
   determining, according to the cross correlation between a first phase pixel and a second phase pixel in each area window, the phase difference corresponding to each area window.

7. An image processing device (600, 700), wherein the device (600, 700) comprises:

   an obtaining unit (601), wherein the obtaining unit (601) comprises multiple photosensitive units, the multiple photosensitive units comprise multiple common photosensitive units and multiple phase photosensitive unit pairs, the multiple common photosensitive units are configured to obtain multiple common pixels, the multiple

EP 3 389 256 B1

phase photosensitive unit pairs are configured to obtain multiple phase pixel pairs, each of the multiple phase photosensitive unit pair comprises a first phase photosensitive unit and a second phase photosensitive unit, the first phase photosensitive unit is a common photosensitive unit that is blocked on the left side,

the second phase photosensitive unit is a common photosensitive unit that is blocked on the right side, the first phase photosensitive unit is configured to obtain a first phase pixel, the second phase photosensitive unit is configured to obtain a second phase pixel, and the multiple common pixels and the multiple phase pixel unit constitute an input image; and

a determining unit (602), configured to divide the input image into at least two area windows, wherein each of the at least two area windows comprises at least two adjacent phase pixel pairs of the multiple phase pixel pairs; the determining unit (602) is further configured to determine, according to the at least two phase pixel pairs in each of the at least two area windows, a phase difference corresponding to each area window; and

the determining unit (602) is further configured to determine, according to the phase difference corresponding to each area window, a depth map corresponding to the input image,

**characterized in that** the determining unit (602) is specifically configured to divide, by using a first length as a step, at least one part of the input image in a first direction into at least two area windows whose sizes are the same, wherein the first direction is a horizontal direction of the input image or a vertical direction of the input image, wherein the first length is determined according to a required resolution of the depth map in a first direction, wherein the first length is greater than or equal to a distance between two adjacent phase pixel pairs in the first direction.

8. The device (600, 700) according to claim 7, wherein the first length is less than a length of each area window in the first direction.

9. The device (600, 700) according to claim 7 or 8, wherein the determining unit (602) is further configured to divide, by using a second length as a step, at least one part of the input image in a second direction into at least two area windows whose sizes are the same, wherein the second direction is perpendicular to the first direction.

10. The device (600, 700) according to claim 9, wherein the second length is greater than or equal to a distance between two adjacent phase pixel pairs in the second direction.

11. The device (600, 700) according to claim 9 or 10, wherein the second length is less than a length of each area window in the second direction.

**Patentansprüche**

1. Bildverarbeitungsverfahren, wobei das Verfahren Folgendes umfasst:

Gewinnen (201) eines Eingabebildes, wobei das Eingabebild mehrere gemeinsame Pixel und mehrere Phasenpixelpaare umfasst, wobei jedes der mehreren Phasenpixelpaare ein erstes Phasenpixel und ein zweites Phasenpixel umfasst, wobei das erste Phasenpixel durch ein fotosensitives Element gewonnen wird, das auf der linken Seite geblockt ist, und das zweite Phasenpixel durch ein fotosensitives Element gewonnen wird, das auf der rechten Seite geblockt ist,

Teilen (202) des Eingabebildes in mindestens zwei Bereichsfenster, wobei jedes der mindestens zwei Bereichsfenster mindestens zwei benachbarte Phasenpixelpaare der mehreren Phasenpixelpaare umfasst,

Bestimmen (203) einer Phasendifferenz, die jedem Bereichsfenster entspricht, gemäß den mindestens zwei Phasenpixelpaaren in jedem der mindestens zwei Bereichsfenster, und

Bestimmen (204) eines Tiefenbildes, das dem Eingabebild entspricht, gemäß der Phasendifferenz, die jedem Bereichsfenster entspricht,

**dadurch gekennzeichnet, dass** das Verfahren ferner das Bestimmen einer ersten Länge gemäß einer erforderlichen Auflösung des Tiefenbildes in einer ersten Richtung umfasst, wobei die erste Länge größer oder gleich einem Abstand zwischen zwei benachbarten Phasenpixelpaaren in der ersten Richtung ist, und

dass das Teilen des Eingabebildes in mindestens zwei Bereichsfenster Folgendes umfasst:

Teilen mindestens eines Teils des Eingabefensters in einer ersten Richtung in mindestens zwei Bereichsfenster, deren Größen gleich sind, mit Hilfe der ersten Länge als ein Schritt, wobei die erste Richtung eine horizontale Richtung des Eingabebildes oder eine vertikale Richtung des Eingabebildes ist.

2. Verfahren nach Anspruch 1, wobei die erste Länge kleiner als eine Länge jedes Bereichsfensters in der ersten

10

Richtung ist.

3. Verfahren nach Anspruch 1 oder 2, wobei das Teilen (202) des Eingabefensters in mindestens zwei Bereichsfenster ferner Folgendes umfasst:
Teilen mindestens eines Teils des Eingabefensters in einer zweiten Richtung in mindestens zwei Bereichsfenster, deren Größen gleich sind, mit Hilfe einer zweiten Länge als ein Schritt, wobei die zweite Richtung senkrecht zur ersten Richtung liegt.

4. Verfahren nach Anspruch 3, wobei die zweite Länge größer als oder gleich einem Abstand zwischen zwei benachbarten Phasenpixelpaaren in der zweiten Richtung ist.

5. Verfahren nach Anspruch 3 oder 4, wobei die zweite Länge kleiner als eine Länge jedes Bereichsfensters in der zweiten Richtung ist.

6. Verfahren nach einem der Ansprüche 1 bis 5, wobei das Bestimmen einer Phasendifferenz, die jedem Bereichsfenster entspricht, gemäß den mindestens zwei Phasenpixelpaaren in jedem der mindestens zwei Bereichsfenster Folgendes umfasst:

Bestimmen einer Kreuzkorrelation zwischen einem ersten Phasenpixel und einem zweiten Phasenpixel in jedem Bereichsfenster gemäß den mindestens zwei Phasenpixelpaaren in jedem der mindestens zwei Bereichsfenster und
Bestimmen der Phasendifferenz, die jedem Bereichsfenster entspricht, gemäß der Kreuzkorrelation zwischen einem ersten Phasenpixel und einem zweiten Phasenpixel in jedem Bereichsfenster.

7. Bildverarbeitungsvorrichtung (600, 700), wobei die Vorrichtung (600, 700) Folgendes umfasst:

eine Gewinnungseinheit (601), wobei die Gewinnungseinheit (601) mehrere fotosensitive Einheiten umfasst, die mehreren fotosensitiven Einheiten mehrere gemeinsame fotosensitive Einheiten und mehrere fotosensitive Phaseneinheitenpaare umfassen, die mehreren gemeinsamen fotosensitiven Einheiten dafür gestaltet sind, mehrere gemeinsame Pixel zu gewinnen, die mehreren fotosensitiven Phaseneinheitenpaare dafür gestaltet sind, mehrere Phasenpixelpaare zu gewinnen, jedes der mehreren fotosensitiven Phaseneinheitenpaare eine erste fotosensitive Phaseneinheit und eine zweite fotosensitive Phaseneinheit umfasst, wobei die erste fotosensitive Phaseneinheit eine gemeinsame fotosensitive Einheit ist, die auf der linken Seite geblockt ist, und die zweite fotosensitive Phaseneinheit eine gemeinsame fotosensitive Einheit ist, die auf der rechten Seite geblockt ist, die erste fotosensitive Phaseneinheit dafür gestaltet ist, ein erstes Phasenpixel zu gewinnen, die zweite fotosensitive Phaseneinheit dafür gestaltet ist, ein zweites Phasenpixel zu gewinnen, und die mehreren gemeinsamen Pixel und die mehreren Phasenpixeleinheiten ein Eingabebild bilden, und
eine Bestimmungseinheit (602), die dafür gestaltet ist, das Eingabebild in mindestens zwei Bereichsfenster zu teilen, wobei jedes der mindestens zwei Bereichsfenster mindestens zwei benachbarte Phasenpixelpaare der mehreren Phasenpixelpaare umfasst,
die Bestimmungseinheit (602) ferner dafür gestaltet ist, gemäß den mindestens zwei Phasenpixelpaaren in jedem der mindestens zwei Bereichsfenster eine Phasendifferenz zu bestimmen, die jedem Bereichsfenster entspricht, und
die Bestimmungseinheit (602) ferner dafür gestaltet ist, gemäß der Phasendifferenz, die jedem Bereichsfenster entspricht, ein Tiefenbild zu bestimmen, das dem Eingabebild entspricht,
**dadurch gekennzeichnet, dass** die Bestimmungseinheit (602) speziell dafür gestaltet ist, mit Hilfe einer ersten Länge als ein Schritt mindestens einen Teil des Eingabebildes in einer ersten Richtung in mindestens zwei Bereichsfenster zu teilen, deren Größen gleich sind, wobei die erste Richtung eine horizontale Richtung des Eingabebildes oder eine vertikale Richtung des Eingabebildes ist, wobei die erste Länge gemäß einer erforderlichen Auflösung des Tiefenbildes in einer ersten Richtung bestimmt wird, wobei die erste Länge größer oder gleich einem Abstand zwischen zwei benachbarten Phasenpixelpaaren in der ersten Richtung ist.

8. Vorrichtung (600, 700) nach Anspruch 7, wobei die erste Länge kleiner als eine Länge jedes Bereichsfenster in der ersten Richtung ist.

9. Vorrichtung (600, 700) nach Anspruch 7 oder 8, wobei die Bestimmungseinheit (602) ferner dafür gestaltet ist, mit Hilfe einer zweiten Länge als ein Schritt mindestens einen Teil des Eingabefensters in einer zweiten Richtung in mindestens zwei Bereichsfenster zu teilen, deren Größen gleich sind, wobei die zweite Richtung senkrecht zur ersten Richtung liegt.

**10.** Vorrichtung (600, 700) nach Anspruch 9, wobei die zweite Länge größer als oder gleich einem Abstand zwischen zwei benachbarten Phasenpixelpaaren in der zweiten Richtung ist.

**11.** Vorrichtung (600, 700) nach Anspruch 9 oder 10, wobei die zweite Länge kleiner als eine Länge jedes Bereichsfensters in der zweiten Richtung ist.

**Revendications**

**1.** Procédé de traitement d'image, le procédé comprenant :

l'obtention (201) d'une image d'entrée, l'image d'entrée comprenant de multiples pixels communs et de multiples paires de pixels de phase, chacune des multiples paires de pixels de phase comprenant un premier pixel de phase et un second pixel de phase,
le premier pixel de phase étant obtenu par un élément photosensible qui est bloqué sur le côté gauche, et le second pixel de phase étant obtenu par un élément photosensible qui est bloqué sur le côté droit ;
la division (202) de l'image d'entrée en au moins deux fenêtres de zone, chacune des au moins deux fenêtres de zone comprenant au moins deux paires de pixels de phase adjacentes des multiples paires de pixels de phase ;
la détermination (203), en fonction des au moins deux paires de pixels de phase dans chacune des au moins deux fenêtres de zone, d'une différence de phase correspondant à chaque fenêtre de zone ; et
la détermination (204), en fonction de la différence de phase correspondant à chaque fenêtre de zone, d'une carte de profondeur correspondant à l'image d'entrée,
**caractérisé en ce que** le procédé comprend en outre la détermination d'une première longueur en fonction d'une résolution requise de la carte de profondeur dans une première direction, la première longueur étant supérieure ou égale à une distance entre deux paires de pixels de phase adjacentes dans la première direction, et **en ce que** la division de l'image d'entrée en au moins deux fenêtres de zone comprend : la division, en utilisant la première longueur comme échelon, d'au moins une partie de l'image d'entrée dans une première direction en au moins deux fenêtres de zone dont les tailles sont les mêmes, la première direction étant une direction horizontale de l'image d'entrée ou une direction verticale de l'image d'entrée.

**2.** Procédé selon la revendication 1, la première longueur étant inférieure à une longueur de chaque fenêtre de zone dans la première direction.

**3.** Procédé selon la revendication 1 ou 2, la division (202) de l'image d'entrée en au moins deux fenêtres de zone comprenant en outre :
la division, en utilisant une seconde longueur comme échelon, d'au moins une partie de l'image d'entrée dans une seconde direction en au moins deux fenêtres de zone dont les tailles sont les mêmes, la seconde direction étant perpendiculaire à la première direction.

**4.** Procédé selon la revendication 3, la seconde longueur étant supérieure ou égale à une distance entre deux paires de pixels de phase adjacentes dans la seconde direction.

**5.** Procédé selon la revendication 3 ou 4, la seconde longueur étant inférieure à une longueur de chaque fenêtre de zone dans la seconde direction.

**6.** Procédé selon l'une quelconque des revendications 1 à 5, la détermination, en fonction des au moins deux paires de pixels de phase dans chacune des au moins deux fenêtres de zone, d'une différence de phase correspondant à chaque fenêtre de zone comprenant :

la détermination, en fonction des au moins deux paires de pixels de phase dans chacune des au moins deux fenêtres de zone, d'une corrélation croisée entre un premier pixel de phase et un second pixel de phase dans chaque fenêtre de zone ; et
la détermination, en fonction de la corrélation croisée entre un premier pixel de phase et un second pixel de phase dans chaque fenêtre de zone, de la différence de phase correspondant à chaque fenêtre de zone.

**7.** Dispositif de traitement d'image (600, 700), le dispositif (600, 700) comprenant :

une unité d'obtention (601), l'unité d'obtention (601) comprenant de multiples unités photosensibles, les multiples unités photosensibles comprenant de multiples unités photosensibles communes et de multiples paires d'unités photosensibles de phase, les multiples unités photosensibles communes étant configurées pour obtenir de multiples pixels communs, les multiples paires d'unités photosensibles de phase étant configurées pour obtenir de multiples paires de pixels de phase, chacune des multiples paires d'unités photosensibles de phase comprenant une première unité photosensible de phase et une seconde unité photosensible de phase, la première unité photosensible de phase étant une unité photosensible commune qui est bloquée sur le côté gauche, la seconde unité photosensible de phase étant une unité photosensible commune qui est bloquée sur le côté droit, la première unité photosensible de phase étant configurée pour obtenir un premier pixel de phase, la seconde unité photosensible de phase étant configurée pour obtenir un second pixel de phase, et les multiples pixels communs et l'unité de pixels de phase multiples constituant une image d'entrée ; et
une unité de détermination (602), configurée pour diviser l'image d'entrée en au moins deux fenêtres de zone, chacune des au moins deux fenêtres de zone comprenant au moins deux paires de pixels de phase adjacentes des multiples unités de pixels de phase ;
l'unité de détermination (602) étant en outre configurée pour déterminer, en fonction des au moins deux paires de pixels de phase dans chacune des au moins deux fenêtres de zone, une différence de phase correspondant à chaque fenêtre de zone ; et
l'unité de détermination (602) étant en outre configurée pour déterminer, en fonction de la différence de phase correspondant à chaque fenêtre de zone, une carte de profondeur correspondant à l'image d'entrée, **caractérisé en ce que** l'unité de détermination (602) est spécifiquement configurée pour diviser, en utilisant une première longueur comme échelon, au moins une partie de l'image d'entrée dans une première direction en au moins deux fenêtres de zone dont les tailles sont les mêmes, la première direction étant une direction horizontale de l'image d'entrée ou une direction verticale de l'image d'entrée, la première longueur étant déterminée en fonction d'une résolution requise de la carte de profondeur dans une première direction, la première longueur étant supérieure ou égale à une distance entre deux paires de pixels de phase adjacentes dans la première direction.

**8.** Dispositif (600, 700) selon la revendication 7, la première longueur étant inférieure à une longueur de chaque fenêtre de zone dans la première direction.

**9.** Dispositif (600, 700) selon la revendication 7 ou 8, l'unité de détermination (602) étant en outre configurée pour diviser, en utilisant une seconde longueur comme échelon, au moins une partie de l'image d'entrée dans une seconde direction en au moins deux fenêtres de zone dont les tailles sont les mêmes, la seconde direction étant perpendiculaire à la première direction.

**10.** Dispositif (600, 700) selon la revendication 9, la seconde longueur étant supérieure ou égale à une distance entre deux paires de pixels de phase adjacentes dans la seconde direction.

**11.** Dispositif (600, 700) selon la revendication 9 ou 10, la seconde longueur étant inférieure à une longueur de chaque fenêtre de zone dans la seconde direction.

First phase pixel

Second phase pixel

Common pixel

FIG. 1

Obtain an input image  201

Divide the input image into at least two area windows  202

Determine, according to at least two phase pixel pairs in each of the at least two area windows, a phase difference corresponding to each area window  203

Determine, according to the phase difference corresponding to each area window, a depth map corresponding to the input image  204

FIG. 2

First area window

Second area window

Third area window

Fourth area window

FIG. 3

First area window

Second area window

Third area window

Fourth area window

Fifth area window

Sixth area window

FIG. 4

+PD     PD=0     −PD            Lens 501     Image sensor 502

Object 504

Object 503

Object 505

D1

D2

FIG. 5

Device 600

Obtaining unit
601

Determining unit
602

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017267178 A1
- US 2015043826 A1
- US 2015319420 A1
- US 2015248744 A1